(19) Europäisches Patentamt
European Patent Office
Office européen des brevets

(11) **EP 4 403 666 A2**

(12) **EUROPEAN PATENT APPLICATION**

(43) Date of publication:
**24.07.2024   Bulletin 2024/30**

(21) Application number: **24180734.6**

(22) Date of filing: **31.05.2022**

(51) International Patent Classification (IPC):
***C23C 14/00*** (2006.01)

(52) Cooperative Patent Classification (CPC):
**C01G 30/026; C01F 7/00; C01G 9/00; C23C 14/08;
C23C 14/3464; C23C 14/3485;** C01P 2002/02;
C01P 2002/52; C01P 2002/54; C01P 2006/40;
C01P 2006/80; H01L 29/66969; H01L 29/7869

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(62) Document number(s) of the earlier application(s) in
accordance with Art. 76 EPC:
**22176408.7 / 4 286 339**

(71) Applicant: **Imec VZW
3001 Leuven (BE)**

(72) Inventors:
• **VAN SETTEN, Michiel Jan
3001 Heverlee (BE)**
• **POURTOIS, Geoffrey
1495 Villers-la-Ville (BE)**
• **DEKKERS, Hendrik F.W.
3300 Tienen (BE)**
• **KAR, Gouri Sankar
3001 Leuven (BE)**

(74) Representative: **Winger
Mouterij 16 bus 101
3190 Boortmeerbeek (BE)**

Remarks:
This application was filed on 07-06-2024 as a
divisional application to the application mentioned
under INID code 62.

(54)     **MIXED METAL OXIDES**

(57)     A transistor comprising a channel layer made of
an amorphous second mixed metal oxide (7) consisting
of:
a) a mixture consisting of 0.25 to 0.45 parts by mole Al,
0.55 to 0.75 parts by mole Zn, and 0.00 to 0.20 parts by
mole of other elements, other than Al and Zn, selected
from metals and metalloids, wherein the sum of all parts
by mole of Al, Zn, and the other elements, other than Al
and Zn, selected from metals and metalloids amounts to
1.00,
b) oxygen, and
c) less than 0.01 parts by mole of non-metallic and
non-metalloid impurities,
wherein the parts by mole are as measured by Rutherford
Backscattering Spectroscopy.

FIG. 1

## Description

## Technical field of the invention

The present invention relates to the field of mixed metal oxides, and more in particular to mixed metal oxides for use as a channel in thin-film transistors (TFT).

## Background of the invention

Thin film transistors are widely used in displays, memory, and logic devices. Due to their possibly intensive long-term use, TFTs preferably comprise chemically stable materials. Furthermore, and more in particular, the material for the channel of a TFT preferably enables high on currents and low off currents, that is, a high current in the on-state and a low current in the off-state.

The process for forming TFTs is often in the back-end-of-line (BEOL) stage of integrated circuit fabrication. Furthermore, in the particular application of 3D memory devices, memory cells comprising transistors, e.g., thin film transistors, are typically stacked so as to form the 3D memory device. In the process of forming a new memory cell above an existing one, it is preferably to avoid temperatures above 400°C so as not to damage any already formed memory cells. However, such a limitation on deposition temperatures severely limit the type of materials that may be deposited for fabricating TFTs. Many materials typically used as channel material require higher crystallization temperatures, which disqualifies them for use in TFTs.

On the contrary, the deposition of amorphous materials does not require reaching these high thermal treatment temperatures. However, the resulting films tend to be associated with significantly lower charge carrier mobilities than their crystalline counterparts. Moreover, to be compatible with silicon technology, the materials are preferably chemically stable against "forming gas" anneal. Amorphous materials are intrinsically less stable than their crystalline counterparts.

The current best amorphous oxide, the metal oxide a-$InGaZnO_4$, i.e., IGZO, has, compared to typical amorphous oxides, relatively good electron mobility. This relatively good electron mobility is due to the interaction of s and d orbitals of the metal cations in a lower part of the conduction band. The strength of the bonds between the cations, and, in addition, the type of cations, drives the effective mobility of the system. The mobility of a-$InGaZnO_4$ and its chemical stability are, however, not sufficiently high. a-$InGaZnO_4$ has rather low electron mobility (approximately 20 to 35 $cm^2$/(V·s)) and low chemical stability.

EP3087614 describes a p-type oxide semiconductor, which contains: a metal oxide containing thallium (Tl), where the metal oxide has been hole doped. JP2010028021 provides a TFT having high field effect mobility and a high ON/OFF ratio and improved to a normally off type, and describes a thin film field-effect transistor includes at least a gate electrode, a gate insulating film, an active layer containing amorphous oxide, a source electrode, and drain electrode, which are formed on a substrate. In the thin film field-effect transistor, a barrier layer is formed only in a region existing between the active layer and at least one of the source electrode and the drain electrode and brought into contact with at least one of the source electrode and the drain electrode. KR20140036176 describes a conductive oxide containing M and O, which are at least one element selected from the group consisting of In, Al, Zn, and Mg, and also contains crystalline AIMO. US2017012138 describes a semiconductor device including a transistor having a high field-effect mobility, stable electrical characteristics, and a small current in an off state. A first electrode is formed over a substrate, a first insulating layer is formed adjacent to a side surface of the first electrode, and a second insulating layer is formed to cover the first insulating layer and be in contact with at least part of a surface of the first electrode. The surface of the first electrode is formed of a conductive material that does not easily transmit an impurity element. The second insulating layer is formed of an insulating material that does not easily transmit an impurity element. An oxide semiconductor layer is formed over the first electrode with a third insulating layer provided therebetween. JP2013175717 describes a transistor manufacturing method comprising: forming an oxide semiconductor film having a partially exposed surface, a gate insulation film; a gate electrode and a sidewall insulation film at least contacting a lateral face of the gate electrode; forming a film containing a metal element at least on the oxide semiconductor film and the sidewall insulation film; subsequently, performing a heat treatment in a nitrogen atmosphere to oxidize a region of the film containing the metal element, which contacts the oxide semiconductor film; and removing the film having an oxidized region and containing the metal element to expose a region of the oxide semiconductor film, which contacts the film having an oxidized region and containing the metal element. US2010295042 describes a field effect transistor which includes an oxide film as a semiconductor layer, the oxide film has a channel part, a source part and a drain part, and the channel part, the source part and the drain part have substantially the same composition except oxygen and an inert gas. JP2017022396 describes a storage element having a latch circuit, a first selection circuit, a second selection circuit, a first nonvolatile storage circuit and a second nonvolatile storage circuit. Each of the first nonvolatile storage circuit and the second nonvolatile circuit has a transistor and a capacitive element. The transistor included in each of the first and second nonvolatile storage circuits is a transistor where a channel is formed in an oxide semiconductor film. The transistor has an extremely low off-state current so that data can be retained for a long time even when the transistor becomes an OFF state after data is input to a node which is a connection point of the transistor and the capacitive element and power supply is stopped. US2012319113 describes that at least part of the oxide semiconductor layer which serves as the channel formation region is thinned by etching and the thickness of the channel formation region is adjusted by the etching. Further, a dopant containing phosphorus (P) or boron (B) is introduced into a thick region of the oxide semiconductor layer to form a source region and a drain region in the oxide semiconductor layer, so that the contact resistance between the source and drain regions and the channel formation region which are connected to each other is reduced.

There is therefore a need in the art for a material and method for forming the material that solves one or more of the above problems.

## Summary of the invention

It is an object of the present invention to provide a good first mixed metal oxide, which comprises Mg, Al, and Sb. It is a further object of the present invention to provide a good method for forming the first mixed metal oxide, and a transistor comprising the first mixed metal oxide.

It is still a further object of the present invention to provide a good transistor comprising a channel layer made of an amorphous second mixed metal oxide, which comprises Al and Zn. It is yet a further object of the present invention to provide a good method for forming the transistor comprising the channel layer made of the amorphous second mixed metal oxide.

The above objectives are accomplished by methods and apparatuses according to the present invention.

It is an advantage of embodiments of the present invention that the mixed metal oxides (i.e., the first mixed metal oxide, and the second mixed metal oxide) may have a good electron mobility. It is an advantage of embodiments of the present invention that a channel in a transistor comprising one of these mixed metal oxides, may exhibit a high current in the on-state, and a low current in the off state.

It is an advantage of embodiments of the present invention that the chemical stability of the mixed metal oxides may be good. It is an advantage of embodiments of the present invention that the mixed metal oxides may have good stability against annealing in a forming gas atmosphere, which is a step that is often performed in semiconductor manufacturing processes.

It is an advantage of embodiments of the present invention that elements making up the mixed metal oxides may be compatible with standard industrial silicon technology.

It is an advantage of embodiments of the present invention that the mixed metal oxides may have good properties for use of the mixed metal oxides in transistors, such as in thin-film transistors (TFT), for example as channel material.

It is an advantage of embodiments of the present invention that the mixed metal oxides may be deposited at temperatures below 400°C. It is an advantage of embodiments of the present invention that the mixed metal oxides may be deposited in the back-end-of-line (BEOL) stage of semiconductor manufacturing processing. For example, silicon devices, e.g., silicon logics, may degrade at temperatures above 400°C. For example, this may further enable stacking memory cells comprising transistors, e.g., thin film transistors, comprising one of the mixed metal oxides. Indeed, any already formed memory cells may not be damaged when forming a memory cell on top of the already formed memory cells.

In a first aspect, the present invention relates to a first mixed metal oxide consisting of: a) a mixture consisting of 0.50 to 0.90 parts by mole Mg, 0.05 to 0.30 parts by mole Al, 0.01 to 0.20 parts by mole Sb, and 0.00 to 0.31 parts by mole of other elements, other than Mg, Al, and Sb, selected from metals and metalloids, wherein the sum of all parts by mole of Mg, Al, Sb, and the other elements, other than Mg, Al, and Sb, selected from metals and metalloids amounts to 1.00, b) oxygen, and c) less than 0.01 parts by mole of non-metallic and non-metalloid impurities, wherein the parts by mole are as measured by Rutherford Backscattering Spectroscopy.

In a second aspect, the present invention relates to a method for forming the first mixed metal oxide according to embodiments of the first aspect of the present invention, comprising depositing a magnesium oxide, an aluminium oxide, an antimony oxide, and optionally one or more other oxides, other than the magnesium oxide, the aluminium oxide, and the antimony oxide, selected from metal oxides and metalloid oxides on a substrate, so as to form the first mixed metal oxide consisting of: a) a mixture consisting of 0.50 to 0.90 parts by mole Mg, 0.05 to 0.30 parts by mole Al, 0.01 to 0.20 parts by mole Sb, and 0.00 to 0.31 parts by mole of other elements, other than Mg, Al, and Sb, selected from metals and metalloids, wherein the sum of all parts by mole of Mg, Al, Sb, and the other elements, other than Mg, Al, and Sb, selected from metals and metalloids amounts to 1.00, b) oxygen, and c) less than 0.01 parts by mole of non-metallic and non-metalloid impurities, wherein the parts by mole are as measured by Rutherford Backscattering Spectroscopy.

In a third aspect, the present invention relates to a transistor comprising the first mixed metal oxide according to embodiments of the first aspect of the present invention.

In a fourth aspect, the present invention relates to a transistor comprising a channel layer made of an amorphous second mixed metal oxide consisting of: a) a mixture consisting of 0.25 to 0.45 parts by mole Al, 0.55 to 0.75 parts by mole Zn, and 0.00 to 0.20 parts by mole of other elements, other than Al and Zn, selected from metals and metalloids, wherein the sum of all parts by mole of Al, Zn, and the other elements, other than Al and Zn, selected from metals and metalloids amounts to 1.00, b) oxygen, and c) less than 0.01 parts by mole of non-metallic and non-metalloid impurities, wherein the parts by mole are as measured by Rutherford Backscattering Spectroscopy.

In a fifth aspect, the present invention relates to a method for forming the transistor according to embodiments of the fourth aspect of the present invention, wherein forming the channel layer of said transistor comprises: depositing an aluminium oxide, a zinc oxide, and optionally one or more other oxides, other than the aluminium oxide, and the zinc oxide, selected from metal oxides and metalloid oxides on a substrate, so as to form the amorphous second mixed metal oxide consisting of: a) a mixture consisting of 0.25 to 0.45 parts by mole Al, 0.55 to 0.75 parts by mole Zn, and 0.00 to 0.20 parts by mole of other elements, other than Al and Zn, selected from metals and metalloids, wherein the sum of all parts by mole of Al, Zn, and the other elements, other than Al and Zn, selected from metals and metalloids amounts to 1.00, b) oxygen, and c) less than 0.01 parts by mole of non-metallic and non-metalloid impurities, wherein the parts by mole are as measured by Rutherford Backscattering Spectroscopy.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

## Brief description of the drawings

FIG. 1 is a schematic representation of a combinatorial physical vapor deposition system for performing a method in accordance with embodiments of the second aspect of the present invention.

FIG. 2 is a schematic representation of a combinatorial physical vapor deposition system for performing a method in accordance with embodiments of the fifth aspect of the present invention.

In the different figures, the same reference signs refer to the same or analogous elements.

## Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

Reference will be made to transistors. These are devices having a first main electrode such as a drain, a second main electrode such as a source, a channel connecting the drain and the source, and a control electrode such as a gate for controlling the flow of electrical charges between the first and second main electrodes, through the channel.

In the context of the present invention, unless otherwise stated, when an amount, e.g., in parts by mole, of an element is mentioned, the amount is as measured by Rutherford Backscattering Spectroscopy.

In the context of the present invention, a metalloid is understood to be an element selected from Arsenic, Tellurium, Germanium, Silicon, Antimony, and Boron.

In a first aspect, the present invention relates to a first mixed metal oxide consisting of: a) a mixture consisting of 0.50 to 0.90 parts by mole Mg, 0.05 to 0.30 parts by mole Al, 0.01 to 0.20 parts by mole Sb, and 0.00 to 0.31 parts by mole of other elements, other than Mg, Al, and Sb, selected from metals and metalloids, wherein the sum of all parts by mole of Mg, Al, Sb, and the other elements, other than Mg, Al, and Sb, selected from metals and metalloids amounts to 1.00, b) oxygen, and c) less than 0.01 parts by mole of non-metallic and non-metalloid impurities, wherein the parts by mole are as measured by Rutherford Backscattering Spectroscopy.

The inventors have found that, surprisingly, the first mixed metal oxide of the invention may have a combination of good electrical conductivity, and good stability, e.g., chemical stability. Without being bound by theory, the first mixed metal oxide having amounts of Mg, Al, and Sb according to the present invention results in a conduction band that is strongly delocalized over cation sites within the first mixed metal oxide, similar to a conduction band of a-InGaZnO$_4$. This results in good electrical conductivity. Furthermore, the first mixed metal oxide of the first aspect of the present invention has a preferred bandgap that is similar or slightly larger than the bandgap of a-InGaZnO$_4$. Thereby, when, for example, the first mixed metal oxide is used as a channel in a transistor, a current through the channel in an off-state of the transistor may be small. Al provides good stability to the first mixed metal oxide. At the same time, increasing the amount of Al in the first mixed metal oxide may further increase the bandgap. An increase in bandgap may result in a reduction in dopability. Therefore, preferably, Al is present in an amount not larger than what is suitable to induce stability to the first mixed metal oxide. The presence of Sb may reduce the bandgap of the first mixed metal oxide. A reduction in bandgap may result in an increase in dopability. Furthermore, Sb may be used to compensate the effect of Al on the bandgap, as the presence of Al may increase the bandgap. At the same time, increasing the amount of Sb in the first mixed metal oxide may reduce the stability of the first mixed metal oxide. Similarly to a-InGaZnO$_4$, doping of the first mixed metal oxide may be induced by an oxygen deficit, compared to a stoichiometric amount of oxygen, in the first mixed metal oxide.

In embodiments, the mixture of the first mixed metal oxide consists of 0.63 to 0.85 parts by mole Mg, 0.08 to 0.25 parts by mole Al, 0.01 to 0.15 parts by mole Sb, and 0.00 to 0.22 parts by mole of other elements, other than Mg, Al, and Sb, selected from metals and metalloids, wherein the sum of all parts by mole of Mg, Al, Sb, and the other elements, other than Mg, Al, and Sb, selected from metals and metalloids amounts to 1.00, wherein the parts by mole are as measured by Rutherford Backscattering Spectroscopy. In embodiments, the mixture of the first mixed metal oxide consists of 0.65 to 0.85 parts by mole Mg, 0.10 to 0.22 parts by mole Al, 0.01 to 0.10 parts by mole Sb, and 0.00 to 0.18 parts by mole of other elements, other than Mg, Al, and Sb, selected from metals and metalloids, wherein the sum of all parts by mole of Mg, Al, Sb, and the other elements, other than Mg, Al, and Sb, selected from metals and metalloids amounts to 1.00, wherein the parts by mole are as measured by Rutherford Backscattering Spectroscopy. In embodiments, the amount of antimony in the mixture is from 0.01 to 0.10, preferably from 0.01 to 0.08, more preferably from 0.01 to 0.06, part by mole.

In embodiments, the oxygen is present in the first mixed metal oxide in an amount that is within 10 mol-%, preferably within 2 mol-%, such as within 1 mol-% of, most preferably equal to, a stoichiometric amount. In embodiments, the amount of oxygen, in moles, in the first mixed metal oxide is within 10 mol-%, preferably within 2 mol-%, such as within 1 mol-% of, most preferably equal to, the sum, in moles, of the stoichiometric amount of oxygen with respect to each metal, and possibly each metalloid, in the mixture. In other words, the combination of the mixture a) and the oxygen b) of the first mixed metal oxide consists of $MgO$, $Al_2O_3$, and $Sb_2O_3$ and possibly one or more other stoichiometric metal oxides and/or one or more stoichiometric metalloid oxides, except for a possible margin of up to 10 mol-%, preferably up to 2 mol-%, such as 1 mol-%, in the amount of oxygen. In embodiments, oxygen is present in an amount in parts per mole that is within 10 mol-%, preferably within 2 mol-%, such as within 1 mol-% of, preferably equal to, the sum, in moles, of the amount of Mg, 1.5 times the amount of Al, and 1.5 times the amount of Sb. In this last embodiment, the first mixed metal oxide may additionally contain oxygen due to oxides of the other elements, other than Mg, Al, and Sb, selected from metals and metalloids. It is an advantage of embodiments of the present invention that the presence of oxygen may facilitate deposition of the first mixed metal oxide at a low temperature.

In embodiments, the amount of the other elements, other than Mg, Al, and Sb, selected from metals and metalloids in the mixture a) of the first mixed metal oxide is from 0.00 to 0.14 parts by mole.

In embodiments, the first mixed metal oxide is in an amorphous phase. It is an advantage of embodiments of the present invention that no crystallization of the first mixed metal oxide may be required. Crystallization may require annealing at very high temperatures, e.g., above 400°C.

Preferably, the first mixed metal oxide is transparent in the visible region of the electromagnetic spectrum. The other elements selected from metals and metalloids, other than Mg, Al, and Sb, may comprise any metal or metalloid, different from Mg, Al, and Sb.

In embodiments, the first mixed metal oxide contains less than 0.001 parts by mole of non-metallic and non-metalloid impurities. In preferred embodiments, the first mixed metal oxide contains less than 0.0005 parts by mole of each non-metallic and non-metalloid impurity, e.g., hydrogen. It is an advantage of embodiments of the present invention that a high purity for the first mixed metal oxide may provide the first mixed metal oxide with good electrical properties.

Any features of any embodiment of the first aspect may be independently as correspondingly described for any embodiment of the second or third aspect of the present invention.

In a second aspect, the present invention relates to a method for forming the first mixed metal oxide according to embodiments of the first aspect of the present invention, comprising depositing a magnesium oxide, an aluminium oxide, an antimony oxide, and optionally one or more other oxides, other than the magnesium oxide, the aluminium oxide, and the antimony oxide, selected from metal oxides and metalloid oxides on a substrate, so as to form the first mixed metal oxide consisting of: a) a mixture consisting of 0.50 to 0.90 parts by mole Mg, 0.05 to 0.30 parts by mole Al, 0.01 to 0.20 parts by mole Sb, and 0.00 to 0.31 parts by mole of other elements, other than Mg, Al, and Sb, selected from metals and metalloids, wherein the sum of all parts by mole of Mg, Al, Sb, and the other elements, other than Mg, Al, and Sb, selected from metals and metalloids amounts to 1.00, b) oxygen, and c) less than 0.01 parts by mole of non-metallic and non-metalloid impurities, wherein the parts by mole are as measured by Rutherford Backscattering Spectroscopy.

In embodiments, the deposition is performed at a temperature of at most 400 °C, preferably in a temperature range of from 200 °C to 400 °C. It is an advantage of embodiments of the present invention that the first mixed metal oxide may be deposited in the BEOL stage of a manufacturing process of a semiconductor structure, and with forming stacks of transistors, e.g., in 3D memory devices, without damaging other components of the semiconductor structure. In embodiments, the substrate comprises a semiconductor device.

In embodiments, the magnesium oxide, the aluminium oxide, the antimony oxide, and the optional one or more other oxides, other than the magnesium oxide, the aluminium oxide, and the antimony oxide, are deposited using physical vapour deposition. It is an advantage of embodiments of the present invention that physical vapour deposition may result in a homogenous, uniform mixture of the oxides. It is an advantage of embodiments of the present invention that physical vapour deposition is compatible with the BEOL stage of semiconductor manufacturing, and with forming 3D memory devices. In embodiments, the substrate comprises silicon. In embodiments, the substrate comprises a monocrystalline silicon wafer.

In embodiments, the physical vapour deposition is performed by sputtering using a magnesium oxide target, an aluminium target, and an antimony oxide target. In embodiments, a first AC potential field is applied to the magnesium oxide target, an AC potential field is applied to the antimony oxide target and a DC potential field is applied to the aluminium target. In preferred embodiments, the DC potential field applied to the aluminium target is a pulsed DC potential field. It is an advantage of embodiments of the present invention that the deposition of the first metal oxide may be efficient. When other elements, other than the magnesium oxide, the aluminium oxide, and the antimony oxide, selected from metal and metalloids are present in the mixture, the deposition of the oxides of these other elements may be performed by sputtering using a corresponding metal or metalloid target or using a corresponding metal oxide or metalloid oxide target.

Any features of any embodiment of the second aspect may be independently as correspondingly described for any embodiment of the first or third aspect of the present invention.

In a third aspect, the present invention relates to a transistor comprising the first mixed metal oxide according to embodiments of the first aspect of the present invention.

In embodiments, the first mixed metal oxide according to embodiments of the first aspect forms a channel layer. It is an advantage of embodiments of the present invention that a charge mobility in the on-stage of the transistor may be high. It is an advantage of embodiments of the present invention that a charge mobility in the off-stage of the transistor may be low.

In embodiments, the transistor is a thin film transistor. In embodiments, the thin film transistor comprises the first mixed metal oxide over, e.g., on, a substrate, e.g., glass or a silicon substrate or a polymer substrate. In embodiments, the thin film transistor comprises a gate material, e.g., indium tin oxide, over, e.g., on, the substrate. The substrate may comprise a semiconductor device. Preferably, the first mixed metal oxide is over the gate material, or the gate material is over the first mixed metal oxide. The gate material is typically separated from the first mixed metal oxide by an insulator material, such as $SiO_2$, $Al_2O_3$, silicon nitride, or $HfO_2$. The first mixed metal oxide typically contacts a drain and a source electrode, which preferably comprise a metal. The process for making thin-film transistors, e.g., channels of thin-film transistors, typically requires particularly low temperatures of formation. It is an advantage of embodiments of the present invention that the combination of good charge mobility, low formation temperature, and chemical stability, may make the first mixed metal oxide according to embodiments of the first aspect of the present invention particularly well-suited for applications in thin film transistors.

Any features of any embodiment of the third aspect may be independently as correspondingly described for any embodiment of the first or second aspect of the present invention.

In a fourth aspect, the present invention relates to a transistor comprising a channel layer made of an amorphous second mixed metal oxide consisting of: a) a mixture consisting of 0.25 to 0.45 parts by mole Al, 0.55 to 0.75 parts by mole Zn, and 0.00 to 0.20 parts by mole of other elements, other than Al and Zn, selected from metals and metalloids, wherein the sum of all parts by mole of Al, Zn, and the other elements, other than Al and Zn, selected from metals and metalloids amounts to 1.00, b) oxygen, and c) less than 0.01 parts by mole of non-metallic and non-metalloid impurities, wherein the parts by mole are as measured by Rutherford Backscattering Spectroscopy.

It is an advantage of embodiments of the fourth aspect of the present invention that elements making up the second mixed metal oxide may be nontoxic.

The inventors have found that, surprisingly, the second mixed metal oxide of the invention may have a combination of good electrical conductivity, and good stability, e.g., chemical stability. Without being bound by theory, the second mixed metal oxide having amounts of Al and Zn according to the present invention results in a conduction band that is strongly delocalized over cation sites within the second mixed metal oxide, similar to a conduction band of a-$InGaZnO_4$. This results in good electrical conductivity. Furthermore, the second mixed metal oxide of the fourth aspect of the present invention has a preferred bandgap that is similar or slightly larger than the bandgap of a-$InGaZnO_4$. Thereby, when, for example, the second mixed metal oxide is used as a channel in a transistor, a current through the channel in an off-state of the transistor may be small. Al provides good stability to the second mixed metal oxide. At the same time, increasing the amount of Al in the second mixed metal oxide may further increase the bandgap. An increase in bandgap may result in a reduction in dopability. Therefore, preferably, Al is present in an amount not larger than what is suitable to induce stability to the second mixed metal oxide.

In embodiments, said mixture of the second mixed metal oxide consists of 0.30 to 0.45 parts by mole Al, 0.55 to 0.70 parts by mole Zn, and 0.00 to 0.20 parts by mole of other elements, other than Al and Zn, selected from metals and metalloids, wherein the sum of all parts by mole of Al, Zn, and the other elements, other than Al and Zn, selected from metals and metalloids amounts to 1.00, wherein the parts by mole are as measured by Rutherford Backscattering Spectroscopy.

In embodiments, the oxygen is present in the second mixed metal oxide in an amount that is within 10 mol-%, preferably within 2 mol-%, such as within 1 mol-% of, most preferably equal to, a stoichiometric amount. In embodiments, the amount of oxygen, in moles, in the second mixed metal oxide is within 10 mol-%, preferably within 2 mol-%, such as within 1 mol-% of, most preferably equal to, the sum, in moles, of the stoichiometric amount of oxygen with respect to each metal, and possibly each metalloid, in the mixture. In other words, the combination of the mixture a) and the oxygen b) of the second mixed metal oxide consists of ZnO, and $Al_2O_3$, and possibly one or more other stoichiometric metal oxides and/or one or more stoichiometric metalloid oxides, except for a possible margin of up to 10 mol-%, preferably up to 2 mol-%, such as 1 mol-%, in the amount of oxygen. In embodiments, oxygen is present in an amount in parts per mole that is within 10 mol-%, preferably within 2 mol-%, such as within 1 mol-% of, preferably equal to, the sum, in moles, of the amount of Zn, and 1.5 times the amount of Al. In this last embodiment, the second mixed metal oxide may additionally contain oxygen due to oxides of the other elements, other than Al and Zn, selected from metals and metalloids. It is an advantage of embodiments of the present invention that the presence of oxygen may facilitate deposition of the second mixed metal oxide at a low temperature.

In embodiments, the amount of the other elements, other than Al and Zn, selected from metals and metalloids in the mixture a) of the second mixed metal oxide is from 0.00 to 0.14 parts by mole.

In embodiments, the second mixed metal oxide is in an amorphous phase. It is an advantage of embodiments of the present invention that no crystallization of the second mixed metal oxide may be required. Crystallization may require annealing at very high temperatures, e.g., above 400°C.

Preferably, the second mixed metal oxide is transparent in the visible region of the electromagnetic spectrum. The other elements selected from metals and metalloids, other than Al and Zn, may comprise any metal or metalloid, different from Al and Zn.

In embodiments, the second mixed metal oxide contains less than 0.001 parts by mole of non-metallic and non-metalloid impurities. In preferred embodiments, the second mixed metal oxide contains less than 0.0005 parts by mole of each non-metallic and non-metalloid impurity, e.g., hydrogen. It is an advantage of embodiments of the present invention that a high purity for the second mixed metal oxide may provide the second mixed metal oxide with good electrical properties.

In embodiments, the transistor is a thin film transistor. In embodiments, the thin film transistor comprises the second mixed metal oxide over, e.g., on, a substrate, e.g., glass or a silicon substrate or a polymer substrate. In embodiments, the thin film transistor comprises a gate material, e.g., indium tin oxide, over, e.g., on, the substrate. The substrate may comprise a semiconductor device. Preferably, the second mixed metal oxide is over the gate material, or the gate material is over the second mixed metal oxide. The gate material is typically separated from the second mixed metal oxide by an insulator material, such as $SiO_2$, $Al_2O_3$, silicon nitride, or $HfO_2$. The second mixed metal oxide typically contacts a drain and a source electrode, which preferably comprise a metal. The process for making thin-film transistors, e.g., channels of thin-film transistors, typically requires particularly low temperatures of formation. It is an advantage of embodiments of the present invention that the combination of good charge mobility, low formation temperature, and chemical stability, may make the second mixed metal oxide according to embodiments of the fourth aspect of the present invention particularly well-suited for applications in thin film transistors.

Any features of any embodiment of the fourth aspect may be independently as correspondingly described for any embodiment of the fifth aspect of the present invention.

In a fifth aspect, the present invention relates to a method for forming the transistor according to embodiments of the fourth aspect of the present invention, wherein forming the channel layer of said transistor comprises: depositing an aluminium oxide, a zinc oxide, and optionally one or more other oxides, other than the aluminium oxide, and the zinc oxide, selected from metal oxides and metalloid oxides on a substrate, so as to form the amorphous second mixed metal oxide consisting of: a) a mixture consisting of 0.25 to 0.45 parts by mole Al, 0.55 to 0.75 parts by mole Zn, and 0.00 to 0.20 parts by mole of other elements, other than Al and Zn, selected from metals and metalloids, wherein the sum of all parts by mole of Al, Zn, and the other elements, other than Al and Zn, selected from metals and metalloids amounts to 1.00, b) oxygen, and c) less than 0.01 parts by mole of non-metallic and non-metalloid impurities, wherein the parts by mole are as measured by Rutherford Backscattering Spectroscopy.

In embodiments, the deposition is performed at a temperature of at most 400 °C, preferably in a temperature range of from 200 °C to 400 °C. It is an advantage of embodiments of the present invention that the second mixed metal oxide may be deposited in the BEOL stage of a manufacturing process of a semiconductor structure, and with forming stacks of transistors, e.g., in 3D memory devices, without damaging other components of the semiconductor structure. In embodiments, the substrate comprises a semiconductor device.

In embodiments, the aluminium oxide, the zinc oxide, and optionally the one or more other oxides, other than the aluminium oxide, and the zinc oxide, are deposited using physical vapour deposition. It is an advantage of embodiments of the present invention that physical vapour deposition may result in a homogenous, uniform mixture of the oxides. It is an advantage of embodiments of the present invention that physical vapour deposition is compatible with the BEOL stage of semiconductor manufacturing, and with forming 3D memory devices. In embodiments, the substrate comprises silicon. In embodiments, the substrate comprises a monocrystalline silicon wafer.

In embodiments, the physical vapour deposition is performed by sputtering using a zinc oxide target and an aluminium target. In embodiments, a first AC potential field is applied to the zinc oxide target, and a DC potential field is applied to the aluminium target. In preferred embodiments, the DC potential field applied to the aluminium target is a pulsed DC potential field. It is an advantage of embodiments of the present invention that the deposition of the second metal oxide may be efficient. When other elements, other than the aluminium oxide and the zinc oxide, selected from metal and metalloids are present in the mixture, the deposition of the oxides of these other elements may be performed by sputtering using a corresponding metal or metalloid target or using a corresponding metal oxide or metalloid oxide target.

Any features of any embodiment of the fifth aspect may be independently as correspondingly described for any embodiment of the fourth aspect of the present invention.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

Example 1: Theoretical calculations for a first mixed metal oxide

First principles theoretical calculations, within the framework of density functional theory using the PBEsol functional, were performed to assess the electrical properties and the stability of a range of mixed metal oxides. Herein, the electrical properties are defined by the magnitude of the bandgap, and the inverse state weighted overlap (ISWO) parameter. The ISWO parameter may define the overlap of orbitals between atoms in a material. A low ISWO value represents a delocalized molecular orbital, whose atomic orbitals are continuously connected between the different atomic sites. A high ISWO value represents a highly localized and poorly connected molecular orbital. The ISWO parameter, and how it may be calculated, is further described in A. de Jamblinne de Meux et al., Method to quantify the delocalization of electronic states in amorphous semiconductors and its application to assessing charge carrier mobility of p-type amorphous oxide semiconductors, Physical Review B 97 (2018) 045208.

In this example, calculations were performed for primary, one metal and oxygen, and binary, two metals and oxygen amorphous oxides, for 12 metals and metalloids (Mg, Al, Si, Ti, Zn, Ga, Zr, Ag, Cd, In, Sn, and Sb). Machine learning (support vector machines) was used to develop predictor functions for oxides containing up to all 12 element and oxygen. A single objective function $F(x)$ (shown below) was developed, that, through minimalization, may be used to predict promising materials.

By varying the weights and target gap in the objective function, it was found that first mixed metal oxides consisting of Mg, Al, and Sb as metal, have very promising properties. Hereinbelow, results are shown for an amorphous first mixed metal oxide consisting of Mg, Al, Sb, and oxygen in a stoichiometric amount, as a function of the amount of Mg, Al, and Sb in the first mixed metal oxide. Herein, x is for the amounts of Mg, Al, and Sb in the first mixed metal oxide.

Reference is made to Table A, which contains values for the ISWO of the conduction band of the first mixed metal oxide, as dependent on the amount of Mg, Al, and Sb in the first mixed metal oxide. Herein, an ISWO of the conduction band of the first mixed metal oxide is defined with respect to an ISWO of the conduction band of a-InGaZnO$_4$, i.e., $\Delta\text{-ISWO}_C = I_c(x)$. Preferably, the ISWO of the conduction band is as low as possible. A low ISWO for the conduction band may correspond to a continuous molecular orbital for the conduction band, and a potentially high charge mobility in the conduction band. For a transistor channel consisting of a material having a low ISWO for the conduction band, there may be a high current through the channel in an on-state of the transistor. The ISWO for the conduction band is found to increase with an increasing concentration of antimony and to decrease with an increasing concentration of Al in the first mixed metal oxide.

Reference is still made to Table A, which, furthermore, contains values for the ISWO of the valence band of the first mixed metal oxide as dependent on the amount of Mg, Al, and Sb in the first mixed metal oxide. Herein, an ISWO of the valence band of the first mixed metal oxide is defined with respect to the ISWO of the valence band of a-InGaZnO$_4$, i.e., $\Delta\text{-ISWO}_V = I_v(x)$. Preferably, the ISWO of the valence band is as high as possible. A high ISWO for the valence band may correspond to a discontinuous molecular orbital for the valence band, and a potentially low charge mobility in the valence band. For a transistor channel consisting of a material having a high ISWO for the valence band, there may be a low current through the channel in an off-state of the transistor. The ISWO for the valence band is found to increase with decreasing concentrations of Sb in the first mixed metal oxide.

Reference is still made to Table A, which, furthermore, contains values for the bandgap of the first mixed metal oxide, as dependent on the amount of Mg, Al, and Sb in the first mixed metal oxide. Herein, a bandgap is defined with respect to the bandgap of a-InGaZnO$_4$, i.e., $\Delta\text{-gap} = G(x)$. Preferably, the bandgap of the first mixed metal oxide is similar to, or a bit, e.g., 1 eV, higher than the bandgap of a-InGaZnO$_4$. It may be observed that the bandgap increases with an increasing concentration of Al, and with a decreasing concentration of Sb. For a transistor comprising a channel comprising the first mixed metal oxide, the large bandgap means that the charge mobility may be low in the off state, and high in the on state of the transistor. However, doping may be increasingly difficult for larger band gaps.

Reference is still made to Table A, which, furthermore, contains values for the energy of formation of the first mixed metal oxide, as dependent on the amount of Mg, Al, and Sb in the mixed metal oxide. A relative energy of formation of the mixed metal oxide is provided that is the difference between: the energy of formation with respect to the energy of formation of isolated atoms of the mixed metal oxide in the gas phase; and the energy of formation with respect to the energy of formation of isolated atoms of a-InGaZnO$_4$ in the gas phase. The relative energy of formation is given as $\Delta$-Eform = Ef(x). Herein, a negative value means that the mixed metal oxide is calculated to be more stable than a-InGaZnO$_4$. It may be observed that the energy of formation reduces, and, correspondingly, the stability increases, with increasing amount of Al, and decreasing amount of Sb.

Table A: Calculated electronic properties, and formation energies, for a range of compositions

| Metal content | $\Delta$-gap=$G(x)$ | $\Delta$-ISWO$_C$=$I_c(x)$ | $\Delta$-ISWO$_V$=$I_V(x)$ | $\Delta$-E$_{form}$=$E_f(x)$ |
|---|---|---|---|---|
| Al$_{0.16}$Mg$_{0.80}$Sb$_{0.05}$ | 0.83 | -0.06 | 5.35 | -1.52 |
| Al$_{0.17}$Mg$_{0.78}$Sb$_{0.05}$ | 0.84 | -0.09 | 5.26 | -1.53 |
| Al$_{0.16}$Mg$_{0.80}$Sb$_{0.04}$ | 0.86 | -0.12 | 5.46 | -1.55 |
| Al$_{0.17}$Mg$_{0.79}$Sb$_{0.04}$ | 0.94 | -0.26 | 5.6 | -1.6 |
| Al$_{0.15}$Mg$_{0.82}$Sb$_{0.03}$ | 0.95 | -0.24 | 5.83 | -1.61 |
| Al$_{0.16}$Mg$_{0.82}$Sb$_{0.03}$ | 0.98 | -0.31 | 5.9 | -1.64 |
| Al$_{0.17}$Mg$_{0.80}$Sb$_{0.03}$ | 0.99 | -0.35 | 5.76 | -1.65 |
| Al$_{0.16}$Mg$_{0.82}$Sb$_{0.02}$ | 1.02 | -0.37 | 5.97 | -1.66 |
| Al$_{0.19}$Mg$_{0.77}$Sb$_{0.03}$ | 1.02 | -0.42 | 5.63 | -1.66 |
| Al$_{0.18}$Mg$_{0.79}$Sb$_{0.03}$ | 1.03 | -0.43 | 5.8 | -1.67 |
| Al$_{0.18}$Mg$_{0.79}$Sb$_{0.02}$ | 1.07 | -0.49 | 5.89 | -1.7 |
| Al$_{0.19}$Mg$_{0.78}$Sb$_{0.03}$ | 1.08 | -0.51 | 5.79 | -1.71 |
| Al$_{0.19}$Mg$_{0.79}$Sb$_{0.02}$ | 1.11 | -0.55 | 5.98 | -1.73 |

To derive an optimum with respect to each of the parameters, an objective function is calculated according to the following formula:

$$F(x) = (G(x) - G_t)^2 + AI_c(x) - BI_v(x) + CE_f(x)$$

wherein G(x) = $\Delta$-gap, $I_C(x)$ = $\Delta$-ISWO$_C$, $I_V(x)$ = $\Delta$-ISWO$_V$, and Ef(x) = $\Delta$-E$_{form}$, each as a function of composition, i.e., amount of Mg, Al, and Sb. Herein, Gt is a target bandgap, and A, B, and C are weight factors. The optimum with respect to material properties corresponds to a minimum in F(x). Herein, for each of Gt and weight factors A, B, and C, the following values were used: Gt: [0, 0.25, 0.5, 0.75, 1]; A: [0.1, 0.2]; B: [0.01, 0.02]; and C: [0.0, 0.5, 1.0, 1.5]. For all these 4x2x2x4 combinations, F(x) is optimized. The values summarized in Table A are all unique solutions of this optimization.

A minimum in F(x) corresponds to a balance between good electrical properties and good stability. According to the present calculations, these properties compare well with, and may be better than, the corresponding properties of InGaZnO$_4$, i.e., IGZO, that is at present generally used in the field of thin-film transistors. Preferred embodiments of the present invention correspond to first mixed metal oxides having an amount of Mg, Al, and Sb, close to that of the optimum.

In addition, it was found from similar calculations as above that second mixed metal oxides consisting of Al and Zn as metal have very promising properties. Hereinbelow, results are shown for an amorphous second mixed metal oxide consisting of Al and Zn, and oxygen in a stoichiometric amount, as a function of the amount of Al and Zn in the second mixed metal oxide. Herein, x is for the amounts of Al and Zn in the second mixed metal oxide.

Reference is made to Table B, which shows results of similar calculations as above, but now for a second mixed metal oxide.

Table B: Calculated electronic properties, and formation energies, for a range of compositions

| Metal content | $\Delta$-gap=$G(x)$ | $\Delta$-ISWO$_C$=$I_c(x)$ | $\Delta$-ISWO$_V$=$I_v(x)$ | $\Delta$-E$_{form}$-$E_f(x)$ |
|---|---|---|---|---|
| Al$_{0.23}$Zn$_{0.77}$ | 0.44 | -0.40 | -2.36 | -0.60 |
| Al$_{0.26}$Zn$_{0.74}$ | 0.51 | -0.38 | -2.31 | -0.71 |
| Al$_{0.29}$Zn$_{0.71}$ | 0.61 | -0.34 | -2.23 | -0.85 |
| Al$_{0.31}$Zn$_{0.69}$ | 0.65 | -0.32 | -2.19 | -0.92 |
| Al$_{0.32}$Zn$_{0.68}$ | 0.67 | -0.31 | -2.17 | -0.95 |
| Al$_{0.33}$Zn$_{0.67}$ | 0.71 | -0.30 | -2.13 | -1.00 |
| Al$_{0.40}$Zn$_{0.60}$ | 0.90 | -0.19 | -1.95 | -1.24 |
| Al$_{0.41}$Zn$_{0.59}$ | 0.93 | -0.17 | -1.92 | -1.28 |

An ISWO of the conduction band of the second mixed metal oxide, defined with respect to an ISWO of the conduction band of a-InGaZnO$_4$, i.e., $\Delta$-ISWOc = $I_c(x)$, increases with an increasing concentration of Al, and with a decreasing concentration of Zn. It may be observed that an ISWO of the valence band of the second mixed metal oxide, defined with respect to the ISWO of the valence band of a-InGaZnO$_4$, i.e., $\Delta$-ISWO$_V$ = $I_v(x)$, increases with an increasing concentration of Al, and with a decreasing concentration of Zn. A bandgap, defined with respect to the bandgap of a-InGaZnO$_4$, i.e., $\Delta$-gap = G(x), increases with an increasing concentration of Al and with a decreasing concentration of Zn. A relative energy of formation E$_{form}$ = Ef(x).of the second mixed metal oxide, which is the difference between the energy of formation with respect to the energy of formation of isolated atoms of the mixed metal oxide in the gas phase, and the energy of formation with respect to the energy of formation of isolated atoms of a-InGaZnO$_4$ in the gas phase, decreases with an increasing concentration of Al, and with a decreasing concentration of Zn.

Example 2a: Method for forming the first mixed metal oxide

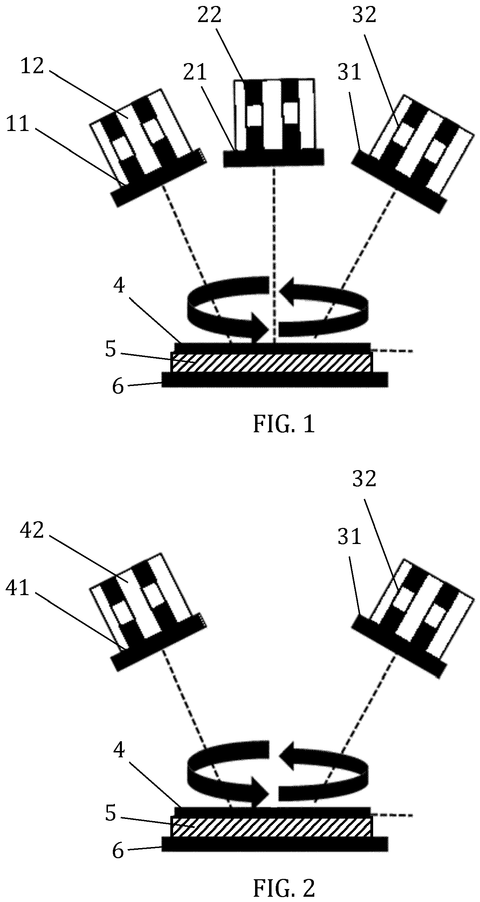

Reference is made to FIG. 1, which is a schematic representation of a combinatorial physical vapour deposition system that may be used for performing a method according to embodiments of the second aspect of the present invention, to form a first mixed metal oxide according to embodiments of the first aspect of the present invention. The combinatorial physical vapour deposition system of this example may deposit oxides, i.e., MgO, Al$_2$O$_3$, and Sb$_2$O$_3$. For the deposition, in the example, three sputter targets 11, 21, and 31 are mounted, each on an individual cathode 12, 22, and 32. Each of the sputter targets 11, 21 and 31 is aimed towards a substrate 5. In this example, the substrate 5 is a 300 mm wide Si wafer. Heating of the substrate 5 may be enabled by clamping the substrate 5 to an electrically heated rotating chuck 6. The deposition is typically performed in an Ar atmosphere, although also other gases may be used. Ar may be ionized and accelerated towards each of the targets 11, 21, and 31, by application of a potential to each of the corresponding cathodes 12, 22, and 32. The impact of the Ar ions on a target 11, 21, or 31 induces release of atoms or atom clusters from the target 11, 21, or 31. This process is referred to as 'sputtering'.

Depending on the conductance of the target 11, 21 or 31, the potential applied to the cathode 12, 22, or 32 may be oscillated. When the target 11, 21, or 31 comprises an oxide material, e.g., MgO, Al$_2$O$_3$, or Sb$_2$O$_3$, the applied potential may oscillate at a frequency inside the radio frequency domain. When the target 11, 21, or 31 is an elemental target, e.g., Mg or Al, a DC potential may be applied. In this example, a MgO target 11 and a Sb$_2$O$_3$ target 21 are powered with an oscillating potential, and an elemental Al target 31 is powered with a pulsed DC potential. To obtain a fully oxidized material with elemental targets, O$_2$ may be added to the sputtering gas. The O$_2$ gas may oxidize the target during the sputtering process, thereby forming an insulating top layer on the target. In that case, a pulsed DC potential is preferably used. Pressure is regulated by the total flow, i.e., Ar flow and O$_2$ flow, and is typically in the range of a few, e.g.,1 to 10, Pa.

A uniform deposition, i.e., a uniform first mixed metal oxide 4, may be achieved by optimization of the aiming angle of the cathodes 12, 22, and 32, and by rotation of the substrate 5 at a high rate. Typically, a deposition rate is low enough to facilitate random mixing of the elements during deposition. Thereby, the deposition may result in a uniform film of the first mixed metal oxide 4. The composition of the film 4, i.e., the amounts of Sb, Mg, and Al in the mixed metal oxide 4, may be regulated by adjusting the potential that is applied to each cathode 12, 22, and 32.

Example 2b: Method for forming the second mixed metal oxide

Reference is made to FIG. 2, which is a schematic representation of a combinatorial physical vapour deposition system that may be used for performing a method according to embodiments of the fifth aspect of the present invention, to form a second mixed metal oxide according to embodiments of the fourth aspect of the present invention. The combinatorial physical vapour deposition system of this example may deposit oxides, i.e., $Al_2O_3$, and ZnO. For the deposition, in the example, two sputter targets 31 and 41 are mounted, each on an individual cathode 32 and 42. Each of the sputter targets 31 and 41 is aimed towards a substrate 5. In this example, the substrate 5 is a 300 mm wide Si wafer. Heating of the substrate 5 may be enabled by clamping the substrate 5 to an electrically heated rotating chuck 6. The deposition is typically performed in an Ar atmosphere, although also other gases may be used. Ar may be ionized and accelerated towards each of the targets 31 and 41, by application of a potential to each of the corresponding cathodes 32 and 42. The impact of the Ar ions on a target 31 and 41 induces release of atoms or atom clusters from the target 31 and 41. This process is referred to as 'sputtering'.

Depending on the conductance of the target 31 and 41, the potential applied to the cathode 32 and 42 may be oscillated. When the target 31 or 41 comprises an oxide material, e.g., ZnO or $Al_2O_3$, the applied potential may oscillate at a frequency inside the radio frequency domain. When the target 31 or 41 is an elemental target, e.g., Al, a DC potential may be applied. In this example, a ZnO target 41 is powered with an oscillating potential, and an elemental Al target 31 is powered with a pulsed DC potential. To obtain a fully oxidized material with elemental targets, $O_2$ may be added to the sputtering gas. The $O_2$ gas may oxidize the target during the sputtering process, thereby forming an insulating top layer on the target. In that case, a pulsed DC potential is preferably used. Pressure is regulated by the total flow, i.e., Ar flow and $O_2$ flow, and is typically in the range of a few, e.g.,1 to 10, Pa.

A uniform deposition, i.e., a uniform second mixed metal oxide 7, may be achieved by optimization of the aiming angle of the cathodes 32 and 42, and by rotation of the substrate 5 at a high rate. Typically, a deposition rate is low enough to facilitate random mixing of the elements during deposition. Thereby, the deposition may result in a uniform film of the second mixed metal oxide 7. The composition of the film 7, i.e., the amounts of Zn and Al in the second mixed metal oxide 7, may be regulated by adjusting the potential that is applied to each cathode 32 and 42.

**Claims**

1. A transistor comprising a channel layer made of an amorphous second mixed metal oxide (7) consisting of:

    a) a mixture consisting of 0.25 to 0.45 parts by mole Al, 0.55 to 0.75 parts by mole Zn, and 0.00 to 0.20 parts by mole of other elements, other than Al and Zn, selected from metals and metalloids, wherein the sum of all parts by mole of Al, Zn, and the other elements, other than Al and Zn, selected from metals and metalloids amounts to 1.00,
    b) oxygen, and
    c) less than 0.01 parts by mole of non-metallic and non-metalloid impurities,

    wherein the parts by mole are as measured by Rutherford Backscattering Spectroscopy.

2. The transistor according to claim 1, wherein said mixture consists of 0.25 to 0.45 parts by mole Al, 0.55 to 0.75 parts by mole Zn, and 0.00 to 0.20 parts by mole of other elements, other than Al and Zn, selected from metals and metalloids, wherein the sum of all parts by mole of Al, Zn, and the other elements, other than Al and Zn, selected from metals and metalloids amounts to 1.00, wherein the parts by mole are as measured by Rutherford Backscattering Spectroscopy.

3. The transistor according to claim 1 or 2, wherein the transistor is a thin film transistor.

4. A method for forming the transistor according to any of claims 1 to 3, wherein forming the channel layer of said transistor comprises:
    depositing an aluminium oxide, a zinc oxide, and optionally one or more other oxides, other than the aluminium oxide, and the zinc oxide, selected from metal oxides and metalloid oxides on a substrate (5), so as to form the amorphous second mixed metal oxide (7) consisting of:

    a) a mixture consisting of 0.25 to 0.45 parts by mole Al, 0.55 to 0.75 parts by mole Zn, and 0.00 to 0.31 parts by mole of other elements, other than Al and Zn, selected from metals and metalloids, wherein the sum of all parts by mole of Al, Zn, and the other elements, other than Al and Zn, selected from metals and metalloids amounts to 1.00,
b) oxygen, and
c) less than 0.01 parts by mole of non-metallic and non-metalloid impurities,

wherein the parts by mole are as measured by Rutherford Backscattering Spectroscopy.

5. The method according to claim 4, wherein the aluminium oxide, the zinc oxide, and optionally the one or more other oxides, other than the aluminium oxide, and the zinc oxide, are deposited using physical vapour deposition.

FIG. 1

FIG. 2

**EP 4 403 666 A2**

**Patent documents cited in the description**

- EP 3087614 A
- JP 2010028021 B
- KR 20140036176
- US 2017012138 A
- JP 2013175717 B
- US 2010295042 A
- JP 2017022396 B
- US 2012319113 A

**Non-patent literature cited in the description**

- **A. DE JAMBLINNE DE MEUX et al.** Method to quantify the delocalization of electronic states in amorphous semiconductors and its application to assessing charge carrier mobility of p-type amorphous oxide semiconductors. *Physical Review B,* 2018, vol. 97, 045208